# EUROPEAN PATENT APPLICATION

(11) **EP 1 950 813 A1**
(43) Date of publication of application: **30.07.2008**
(21) Application number: 06832458.1
(22) Date of filing: 09.11.2006
(51) Int. Cl.: H01L 31/04, H01L 31/0224, H01L 31/0236, H01B 5/14, H01B 13/00

(54) **TRANSPARENT CONDUCTIVE SUBSTRATE FOR SOLAR CELL AND PROCESS FOR PRODUCING THE SAME**

(30) Priority: 17.11.2005 JP 2005333185
(71) Applicant: Asahi Glass Company, Limited, Chiyoda-ku Tokyo 100-8405 (JP)
(72) Inventor: MATSUI, Yuji, Tokyo; 1008405 (JP)
(74) Representative: Müller-Boré & Partner Patentanwälte
(86) International application number: PCT/JP2006/322397
(87) International publication number: WO 2007/058118

(57) **Abstract**

To provide a transparent conductive substrate for solar cells, whereby the resistance of the tin oxide layer is low, and the absorption of near infrared light by the tin oxide layer is low.

A transparent conductive substrate for solar cells, which has at least two types of layers including a silicon oxide layer and multi-laminated tin oxide layers adjacent to the silicon oxide layer, formed on a substrate in this order from the substrate side, wherein the multi-laminated tin oxide layers include at least one tin oxide layer doped with fluorine and at least one tin oxide layer not doped with fluorine.

## Description

### TECHNICAL FIELD

The present invention relates to a transparent conductive substrate for solar cells and a method for producing the substrate.

### BACKGROUND ART

Solar cells are desired to have their photoconversion efficiency increased in order to utilize the incident sunlight energy to the maximum extent.

As a means to increase the photoelectric conversion efficiency, it is known to increase the electric current flowing through a transparent conductive substrate for solar cells to be used as an electrode for solar cells. For such a purpose, it is known to increase the haze factor, and a method of forming irregularities on the surface of a conductive film is, for example, known (e.g. Patent Documents 1 and 2).

Further, a transparent conductive substrate for solar cells which is used as an electrode for solar cells, is usually constructed by forming a transparent conductive oxide film on a substrate excellent in light transmittance, such as glass. For such a transparent conductive substrate for solar cells, a laminated film having a silicon oxide layer and a tin oxide layer formed in this order from the substrate side, or a laminated film having a titanium oxide layer, a silicon oxide layer and a tin oxide layer formed in this order form the substrate side, has been suitably employed. And, in order to improve the electrical conductivity (i.e. in order to lower the resistance) of the tin oxide layer in such a laminated film thereby to improve the performance as an electrode, it is common to have the tin oxide layer doped with fluorine (e.g. Patent Document 2).
Patent Document 1: JP-A-2002-260448
Patent Document 2: JP-A-2001-36117

### DISCLOSURE OF THE INVENTION

### PROBLEMS TO BE SOLVED BY THE INVENTION

However, as a result of a study by the present inventors, it has been found that if the amount of fluorine to be doped is increased in order to lower the resistance of the tin oxide layer, there will be a problem that the absorption of near infrared light will increase.

Accordingly, it is an object of the present invention to provide a transparent conductive substrate for solar cells, whereby the resistance of the tin oxide layer is low, and the absorption of near infrared light by the tin oxide layer is low.

Further, as a result of a study by the present inventors, it has been found that if the amount of fluorine to be doped is increased in order to lower the resistance of the tin oxide layer, the haze factor will decrease particularly when a titanium oxide layer is present between the substrate and the silicon oxide layer.

Accordingly, it is a further object of the present invention to provide a transparent conductive substrate for solar cells, whereby the haze factor will not decrease even when a titanium oxide layer is present between the substrate and the silicon oxide layer.

### MEANS TO SOLVE THE PROBLEMS

As a result of an extensive research to accomplish the above objects, the present inventors have fount it possible to lower the absorption of near infrared light by reducing the amount of fluorine as a whole while securing excellent electrical conductivity in the plane direction in a region where the fluorine amount is large, by providing a region where the amount of doped fluorine is large and a region where such an amount is small in the thickness direction of the tin oxide layer.

Further, the present inventors have found that the haze value will not decrease even when a titanium oxide layer is present between the substrate and the silicon oxide layer, by reducing the amount of fluorine in a region in the vicinity of the interface between the tin oxide layer and the silicon oxide layer.

The present invention is based on the above discoveries and provides the following (i) to (ix).
(i) A transparent conductive substrate for solar cells, which has at least two types of layers including a silicon oxide layer and multi-laminated tin oxide layers adjacent to the silicon oxide layer, formed on a substrate in this order from the substrate side, wherein the multi-laminated tin oxide layers include at least one tin oxide layer doped with fluorine and at least one tin oxide layer not doped with fluorine.
(ii) The transparent conductive substrate for solar cells according to the above (i), wherein a first tin oxide layer being a tin oxide layer adjacent to the silicon oxide layer is the tin oxide layer not doped with fluorine.
(iii) The transparent conductive substrate for solar cells according to the above (ii), wherein the fluorine concentration in the first tin oxide layer is not more than 20% of the fluorine concentration in the tin oxide layer doped with fluorine.
(iv) The transparent conductive substrate for solar cells according to the above (ii) or (iii), wherein the first tin oxide layer has a thickness of at least 10 nm.
(v) A transparent conductive substrate for solar cells, which has at least two types of layers including a silicon oxide layer and a tin oxide layer adjacent to the silicon oxide layer, formed on a substrate in this order from the substrate side, wherein the tin oxide layer has a thickness of from 600 to 1,000 nm; in the tin oxide layer, the fluorine concentration in a region (1) of up to 200 nm from the interface with the silicon oxide layer is not more than 20% of the fluorine concentration in a region (3) of up to 300 nm from the surface of the tin oxide layer on the side opposite to the substrate; and the fluorine concentration in a region (2) between the regions (1) and (3) in the tin oxide layer is at least the fluorine concentration in the region (1) and at most the fluorine concentration in the region (3).
(vi) The transparent conductive substrate for solar cells according to any one of the above (i) to (v), which further has a titanium oxide layer between the substrate and the silicon oxide layer.
(vii) A solar cell employing the transparent conductive substrate for solar cells according to any one of the above (i) to (vi).
(viii) A method for producing a transparent conductive substrate for solar cells, which comprises forming at least 3 types of layers including a silicon oxide layer, a tin oxide layer not doped with fluorine and a tin oxide layer doped with fluorine, in this order on a substrate, by means of an atmospheric pressure CVD method, to obtain a transparent conductive substrate for solar cells.
(ix) A method for producing a transparent conductive substrate for solar cells, which comprises forming at least two types of layers including a silicon oxide layer and a tin oxide layer, in this order on a substrate, by means of an atmospheric pressure CVD method, to obtain a transparent conductive substrate for solar cells, wherein onto the substrate having the silicon oxide layer formed thereon, the tin oxide layer is formed by blowing a source gas having a hydrogen fluoride concentration increased from upstream towards downstream while the substrate is being moved, from a plurality of gas supply devices disposed along the direction of the movement of the substrate.

### EFFECTS OF THE INVENTION

The transparent conductive substrate for solar cells of the present invention has a feature that the resistance of the tin oxide layer is low, and the absorption of near infrared light by the tin oxide layer is low.

### BRIEF DESCRIPTION OF THE DRAWINGS

Fig. 1 is a schematic cross-sectional view illustrating a first embodiment of the transparent conductive substrate for solar cells of the present invention.
Fig. 2 is a schematic perspective view illustrating a production apparatus to be used for the production of the first embodiment of the transparent conductive substrate for solar cells of the present invention.
Fig. 3 is a schematic cross-sectional view illustrating a solar cell of a tandem structure employing the first embodiment of the transparent conductive substrate for solar cells of the present invention.

### EXPLANATION OF REFERENCE NUMERALS

10: Transparent conductive substrate for solar cells
12: Substrate
14: Titanium oxide layer
16: Silicon oxide layer
18: First tin oxide layer
20: Second tin oxide layer
22: First photoelectric conversion layer
24: Second photoelectric conversion layer
26: Semiconductor layer (photoelectric conversion layer)
28: Rear side electrode layer
50: Production apparatus
52: Main body
54: Conveyer belt
56: Belt-driving device
57: Heating zone
58a to 58d: Gas supply devices (injectors)
60a to 60d: Gas flow rate-controlling devices
61: Annealing zone
62: Brush cleaner
64: Ultrasonic wave cleaner
66: Belt dryer
100: Solar cell

### BEST MODE FOR CARRYING OUT THE INVENTION

Now, the transparent conductive substrate for solar cells of the present invention will be described in detail with reference to preferred embodiments shown in the attached drawings. Firstly, the first embodiment of the present invention will be described.

The first embodiment of the present invention is a transparent conductive substrate for solar cells, which has at least a silicon oxide layer and multi-laminated tin oxide layers adjacent to the silicon oxide layer, formed on a substrate in this order from the substrate side, wherein the multi-laminated tin oxide layers include at least one tin oxide layer doped with fluorine and at least one tin oxide layer not doped with fluorine.

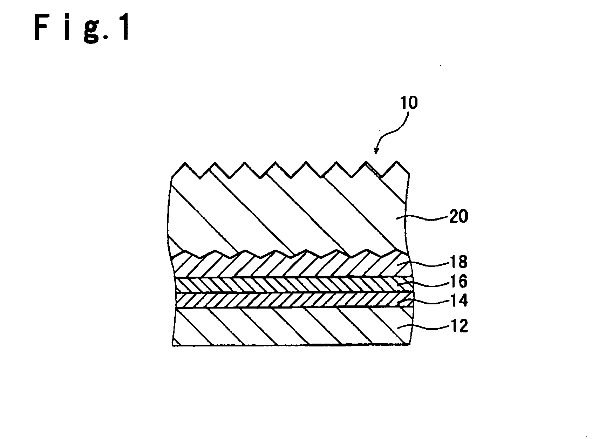

Fig. 1 is a schematic cross-sectional view illustrating one practical example of the first embodiment of the transparent conductive substrate for solar cells of the present invention. In Fig. 1, the incident light side of the transparent conductive substrate for solar cells is located on the down side of the drawing.

As shown in Fig. 1, the transparent conductive substrate 10 for solar cells has a titanium oxide layer 14, a silicon oxide layer 16, a first tin oxide layer 18 and a second tin oxide layer 20 on a substrate 12 in this order from the substrate 12 side.

The material for the substrate 12 is not particularly limited, but glass or a plastic may, for example, be preferably mentioned from the viewpoint of being excellent in the light transmitting property (the light transmittance) and the mechanical strength. Among them, glass is particularly preferred from the viewpoint of being excellent in the light transmittance, the mechanical strength and the heat resistance and excellent also from the aspect of costs.

The glass is not particularly limited, and it may, for example, be soda lime silicate glass, aluminosilicate glass, lithium aluminosilicate glass, quartz glass, borosilicate glass or alkali-free glass. Among them, soda lime silicate glass is particularly preferred from the viewpoint of being colorless transparent, inexpensive and readily available in the market by specifying the specification for e.g. the area, shape, thickness, etc.

In a case where the substrate 12 is made of glass, the thickness is preferably from 0.2 to 6.0 mm. Within this range, the balance between mechanical strength and the light transmitting property will be excellent.

The substrate 12 is preferably one excellent in the light transmittance within a wavelength region of from 400 to 1,200 nm. Specifically, it is preferred that the average light transmittance within a wavelength region of from 400 to 1,200 nm exceeds 80%, and it is more preferably at least 85%.

Further, the substrate 12 is preferably one excellent in the insulating properties and preferably one excellent also in the chemical durability and the physical durability.

The substrate 12 shown in Fig. 1 is a flat plate with a flat cross-sectional shape. However, in the present invention, the cross-sectional shape of the substrate is not particularly limited, and it may be suitably selected depending upon the shape of the solar cell to be produced by employing the substrate 12. Namely, the cross-sectional shape may be a curved shape or any other irregular shape.

In Fig. 1, the titanium oxide layer 14 is formed on the substrate 12. In the present invention, when the substrate is made of glass, an embodiment having a titanium oxide layer between the substrate and a silicon oxide layer is one of preferred embodiments, since it is possible to suppress reflection at the interface between the substrate and the tin oxide layer which takes place due to the difference in the refractive index between the substrate and the tin oxide layer.

The titanium oxide layer 14 is a layer made of TiO₂ having a higher refractive index than the substrate 12 to a light within a wavelength region of from 400 to 1,200 nm. The titanium oxide layer 14 is a layer composed substantially of TiO₂, and the proportion of TiO₂ among components contained in the layer is preferably at least 90 mol%, more preferably at least 95 mol%, further preferably at least 98 mol%.

The titanium oxide layer 14 preferably has a thickness of at least 5 nm and less than 22 nm, more preferably from 10 to 20 nm. Within such a range, the fluctuation in the haze factor for illuminant C is small when the transparent conductive substrate 10 for solar cells is viewed as a whole, and by the anti-reflection effects, the light transmittance, particularly the light transmittance within a wavelength region of from 400 to 1,200 nm, can be made higher.

The titanium oxide layer 14 preferably has a surface arithmetic average roughness (Rₐ) of at most 3 nm, more preferably at most 1 nm, as measured by an atomic force microscope (AFM), before the silicon oxide layer 16 is formed thereon.

Further, in the first embodiment of the present invention, a tin oxide layer may be formed instead of the titanium oxide layer 14.

On the titanium oxide layer 14, a silicon oxide layer 16 is formed.

The silicon oxide layer 16 is a layer made of SiO₂ having a lower refractive index than the substrate 12, the first tin oxide layer 18 and the second tin oxide layer 20 to a light within a wavelength region of from 400 to 1,200 nm. The silicon oxide layer 16 is a layer composed substantially of SiO₂, and the proportion of SiO₂ among the components contained in the layer is preferably at least 90 mol%, more preferably at least 95 mol%, further preferably at least 98 mol%.

In a case where the titanium oxide layer is present, the silicon oxide layer 16 preferably has a thickness of from 10 to 50 nm, more preferably from 20 to 40 nm, further preferably from 20 to 35 nm. Within such a range, the haze factor for illuminant C of the transparent conductive substrate for solar cells will be high, and the fluctuation in the haze factor for illuminant C is small when the transparent conductive substrate 10 for solar cells is viewed as a whole. Further, in a case where no titanium oxide layer is present, the thickness of the silicon oxide layer 16 preferably has a thickness of at least about 20 nm. The thickness of the silicon oxide layer should better be thick as the after-mentioned alkali barrier layer, but in a case where the anti-reflection effects are to be obtained by setting two layers of the titanium oxide layer and the silicon oxide layer, the respective thicknesses of the titanium oxide layer and the silicon oxide layer, and their combination, are restricted.

The silicon oxide layer 16 preferably has a surface arithmetic average roughness (Rₐ) of at most 3 nm, more preferably at most 1 nm, as measured by an atomic force microscope (AFM), before the first tin oxide layer 18 is formed thereon.

In a case where the substrate is made of glass, the silicon oxide layer 16 suppresses diffusion of alkali metal ions from the substrate.

Further, the silicon oxide layer 16 functions as a reflective-preventive layer in combination with the titanium oxide layer 14. If the titanium oxide layer 14 and the silicon oxide layer 16 were not present, the transparent conductive substrate 10 for solar cells would have a reflection loss of incident light due to the difference in the refractive index to a light within a wavelength region of from 400 to 1,200 nm between the substrate 12 and the first tin oxide layer 18. However, the transparent conductive substrate 10 for solar cells has the silicon oxide layer 16 having a lower refractive index to light within a wavelength region of from 400 to 1,200 nm than the titanium oxide layer 14 and the first tin oxide layer 18 having a higher refractive index to a light within a wavelength region of from 400 to 1,200 nm than the substrate 12, between the substrate 12 and the first tin oxide layer 18, whereby the reflection loss of incident light will be reduced, and the light transmittance, particularly the light transmittance within a wavelength region of from 400 to 1,200 nm, will be high.

Further, in a case where the material for the substrate 12 is a glass containing alkali metal ions such as soda lime silicate glass or low alkali-containing glass, the silicon oxide layer will function also as an alkali barrier layer to minimize the diffusion of alkali metal ions from the substrate 12 to the first tin oxide layer 18.

On the silicon oxide layer 16, the first tin oxide layer 18 is formed, and on the first tin oxide layer 18, the second tin oxide layer 20 is formed.

Here, in the first embodiment of the transparent conductive substrate for solar cells of the present invention, the multi-laminated tin oxide layers include at least one tin oxide layer doped with fluorine and at least one tin oxide layer not doped with fluorine, whereby the absorption of near infrared light by the tin oxide layers can be reduced, while the resistance of the tin oxide layers is maintained to be low.

The following description will be made with reference to e.g. a case where the first tin oxide layer 18 is a tin oxide layer not doped with fluorine, and the second tin oxide layer 20 is a tin oxide layer doped with fluorine.

Usually, if a tin oxide layer is doped with fluorine, the amount of free electrons in the layer will increase. In the transparent conductive substrate 10 for solar cells, the first tin oxide layer 18 is not doped with fluorine, whereby the amount of free electrons in the layer is small as compared with the second tin oxide layer 20 doped with fluorine. The free electrons in the layer will lower the resistance and increase the electrical conductivity. From such a viewpoint, the larger the amount the better. However, they tend to absorb near infrared light, whereby light reaching to the semiconductor layer will be reduced. From such a viewpoint, the smaller the amount, the better. Therefore, in a conventional conductive transparent substrate for solar cells, it has been extremely difficult to suppress absorption of near infrared light while lowering the resistance in the tin oxide layer doped with fluorine.

In the present invention, while the second tin oxide layer 20 is doped with fluorine, the first tin oxide layer 18 is not doped with fluorine, whereby as compared with the conventional transparent conductive substrate for solar cells wherein the entire tin oxide layer is doped with fluorine, the entire amount of fluorine doped, can be made small, and accordingly, the entire amount of free electrons in the layer can be made small. As a result, it is possible to lower the absorption of near infrared light as compared with the conventional transparent conductive substrate for solar cells.

On the other hand, the electric current flows mainly through the second tin oxide layer 20 having a large amount of free electrons and a low resistance, whereby there will be little influence by the first tin oxide layer 18 having a high resistance. Namely, as the tin oxide layers as a whole, electrical conductivity of the same degree can be secured as compared with the conventional transparent conductive substrate for solar cells wherein the entire tin oxide layer is doped with fluorine.

Thus, in the first embodiment of the present invention, it is possible to reduce the absorption of near infrared light by reducing the amount of fluorine as a whole, while securing excellent electrical conductivity in the plane direction in the region where the amount of fluorine is large.

The tin oxide layer doped with fluorine is a layer composed mainly of SnO₂, and the proportion of SnO₂ among the components contained in the layer is preferably at least 90 mol%, more preferably at least 95 mol%.

The concentration of fluorine in the tin oxide layer doped with fluorine is preferably from 0.01 to 4 mol%, more preferably from 0.02 to 2 mol%, to SnO₂.

Within such a range, the electrical conductivity will be excellent.

In the tin oxide layer doped with fluorine, the free electron density is high, as it is doped with fluorine. Specifically, the free electron density is preferably from 5×10¹⁹ to 4×0²⁰ cm⁻³, more preferably from 1×10²⁰ to 2×10²⁰ cm⁻³. Within such a range, the balance between the electrical conductivity and the absorption of near infrared light will be excellent.

The tin oxide layer not doped with fluorine may be layer composed substantially of SnO₂ and may contain fluorine to some extent. For example, it may contain fluorine to some extent as a result of transfer and diffusion of fluorine from the tin oxide layer doped with fluorine.

In the tin oxide layer not doped with fluorine, the proportion of SnO₂ among components contained in the layer, is preferably at least 90 mol%, more preferably at least 95 mol%, further preferably at least 98 mol%. Within such a range, absorption of near infrared light can be made sufficiently low.

The multi-laminated tin oxide layers preferably has a sheet resistance of from 8 to 20 Ω/□, more preferably from 8 to 12 Ω/□, as a whole.

The multi-laminated tin oxide layers preferably have a total thickness of from 600 to 1,200 nm, more preferably from 700 to 1,000 nm. Within such a range, the haze factor for illuminant C of the transparent conductive substrate 10 for solar cells will be particularly high, and its fluctuation will be particularly small. Further, the light transmittance, particularly the light transmittance within a wavelength region of from 400 to 1,200 nm, will be particularly high, and the electrical conductivity of the tin oxide layers will be particularly excellent. Here, in a case where the after-mentioned surface irregularities are present, the thickness of the tin oxide layers is a value including such irregularities (the thickness to the top of protrusions). Specifically, it is measured by a stylus-type thickness meter.

The thickness of the tin oxide layer not doped with fluorine (the total thickness in a case where a plurality of such layers are present) is preferably from 10 to 600 nm, more preferably from 20 to 500 nm. Within such a range, the effect to suppress the absorption of near infrared light will be sufficiently large.

The thickness of the tin oxide layer doped with fluorine (the total thickness in a case where a plurality of such layers are present) is preferably from 100 to 700 nm, more preferably from 200 to 500 nm. Within such a range, the effects to lower the resistance will be sufficiently large.

The ratio of the thickness of the tin oxide layer not doped with fluorine (the total thickness in a case where a plurality of such layers are present) to the thickness of the tin oxide layer doped with fluorine (the total thickness in a case where a plurality of such layers are present) is preferably 3/7 to 7/3. Within such a range, the balance between the effects to suppress the absorption of near infrared light and the effects to lower the resistance will be excellent.

In the first embodiment of the present invention, the first tin oxide layer 18 being a tin oxide layer adjacent to the silicon oxide layer is preferably a tin oxide layer not doped with fluorine.

As described hereinafter, in the first embodiment of the present invention, one having a titanium oxide layer between the substrate and the silicon oxide layer is one of preferred embodiments. However, the present inventors have found that in an embodiment having a titanium oxide layer, the function as an alkali barrier layer of the silicon oxide layer tends to be low. Consequently, if the substrate is a glass containing alkali metal ions, the alkali metal ions such as sodium ions tend to pass through the silicon oxide layer and move to the interface with the first tin oxide layer. The alkali metal ions such as sodium ions have a function to reduce the size of crystallites during the formation of the first tin oxide layer, whereby the irregularities on the surface of the tin oxide layer tend to be small (the details will be described hereinafter), and consequently the haze factor tends to be small.

Here, in a case where the first tin oxide layer is not doped with fluorine, the size of crystallites tends to be large as compared with a case where the first tin oxide layer is doped with fluorine, whereby the surface irregularities of the tin oxide layer tend to be large, and the haze factor tends to be large, such being desirable. The reason may be such that when the first tin oxide layer is doped with fluorine, F- will electrically attract Na⁺, etc., thereby to accelerate the movement of the alkali metal ions to the interface with the first tin oxide layer, while such will not happen if the first tin oxide layer is not doped with fluorine.

Namely, in a case where anti-reflection effects are to be obtained by a combination of the titanium oxide layer and the silicon oxide layer, the thickness of the silicon oxide layer is restricted, and when a tin oxide layer doped with fluorine is formed on the silicon oxide layer, the haze factor tends to be small. In order to cope with the reduction of the haze factor, a tin oxide layer not doped with fluorine will be required on the silicon oxide layer.

In a case where the first tin oxide layer 18 is not doped with fluorine, the fluorine concentration in the first tin oxide layer 18 is preferably not more than 20% of the fluorine concentration in the tin oxide layer doped with fluorine (the second tin oxide layer 20).

Even if the first tin oxide layer 18 is not doped with fluorine, if the adjacent second tin oxide layer 20 is doped with fluorine, during its film-forming process, a part of such fluorine will move and diffuse into the first tin oxide layer 18. Even if the fluorine is diffused, if the fluorine concentration in the first tin oxide layer 18 is not more than 20% of the fluorine concentration in the second tin oxide layer 20, the function to reduce the size of crystallites will be suppressed, the surface irregularities of the tin oxide layer will be large, and the haze factor will be sufficiently large.

In the present invention, the fluorine concentration is measured by means of Secondary Ion Mass Spectroscopy (SIMS). Specifically, the fluorine concentration can be calculated from the counted amount of F ions measured by means of SIMS.

Depending upon sputtering ions to be used, the sensitivity to Sn ions and the sensitivity to F ions are different. However, so long as the same sputtering ions are employed, the sensitivity will be constant. Accordingly, by using the same sputtering ions, it is possible to compare the ratio of the counted amount of Sn ions to the counted amount of F ions at different measuring portions. Further, when the fluorine concentration is to be obtained by mol% to SnO₂ as mentioned above, a sample having the fluorine concentration in the SnO₂ matrix preliminarily quantified, is subjected to measurements of the counted amount of SnO₂ ions and the counted amount of F ions, by means of SIMS, and then the fluorine concentration is calculated.

The thickness of the first tin oxide layer is preferably at least 10 nm, more preferably at least 50 nm, since the crystallites will thereby be large.

Further, the first tin oxide layer usually covers the entire surface of the silicon oxide layer. However, in the present invention, a part thereof may not be covered. Namely, there may be a portion where the silicon oxide layer and the second tin oxide layer are in direct contact with each other. In such a case, the first tin oxide layer may be non-continuous (in other words, the first tin oxide layer may be scattered in the form of islands on the silicon oxide layer).

As shown in Fig. 1, the multi-laminated tin oxide layers preferably have irregularities over the entire surface on the opposite side to the incident light side (in Fig. 1, on the upper surface of the second tin oxide layer 20). With respect to the degree of irregularities, the height difference (height difference between protrusions and recesses) is preferably from 0.1 to 0.5 µm, more preferably from 0.2 to 0.4 µm. Further, the pitch between the protrusions of the irregularities (the distance between the peaks of adjacent protrusions) is preferably from 0.1 to 0.75 µm, more preferably from 0.2 to 0.45 µm.

When the tin oxide layer has irregularities on its surface, the haze factor of the transparent conductive substrate 10 for solar cells will be high due to light scattering. Further, it is preferred that such irregularities are uniform over the entire surface of the tin oxide layer, since the fluctuation in the haze factor will thereby be small.

When the transparent conductive substrate for solar cells has irregularities on the surface of the tin oxide layer, the haze factor will be large. Further, when the tin oxide layer has irregularities on its surface, light will be refracted at the interface between the tin oxide layer and a semiconductor layer. Further, when the tin oxide layer has irregularities on its surface, the interface of the semiconductor layer formed thereon with the rear electrode layer will likewise have irregularities, whereby light tends to be readily scattered.

When the haze factor becomes large, an effect such that the length (light path length) for light to travel back and forth through the semiconductor layer between the transparent conductive film (the tin oxide layer thereof) and the rear electrode layer will be long (an effect to trap light in) will be obtained, whereby the electric current value will increase.

A method for forming such irregularities on the surface of the tin oxide layer is not particularly limited. The irregularities will be composed of crystallites exposed on the surface of the tin oxide layer remotest from the substrate on the opposite side to the incident light side.

Usually, in the multi-laminated tin oxide layers, it is possible to adjust the size of crystallites in the tin oxide layer remotest from the substrate by adjusting the size of crystallites in the first tin oxide layer, whereby the irregularities can be controlled to be within the above-mentioned preferred range. Also in the transparent conductive substrate 10 for solar cells shown in Fig. 1, the first tin oxide layer 18 has irregularities on its surface, whereby the second tin oxide layer 20 has irregularities on its surface.

In order to enlarge the size of crystallites in the first tin oxide layer, a method may, for example, be mentioned wherein the concentration of fluorine is made small without doping fluorine, as mentioned above.

The thickness of the transparent conductive film formed on the substrate (in the transparent conductive substrate 10 for solar cells shown in Fig. 1, the total of the thicknesses of the first tin oxide layer 18 and the second tin oxide layer 20) is preferably from 600 to 1,200 nm. Within such a range, the irregularities will not be too deep, whereby uniform coating with silicon will be facilitated, and the cell efficiency is likely to be excellent. Namely, the thickness of the p-layer in the pin layer structure of a photoelectric conversion layer is usually at a level of a few tens nm, and accordingly, if the irregularities are too deep, the irregularities are likely to have structural defects, or the raw material diffusion to the recessed portions tends to be insufficient, whereby uniform coating tends to be difficult, and the cell efficiency is likely to deteriorate.

The first embodiment of the transparent conductive substrate for solar cells of the present invention is not particularly restricted with respect to the method for its production. For example, a method may preferably be mentioned wherein at least a silicon oxide layer, a tin oxide layer not doped with fluorine and a tin oxide layer doped with fluorine are formed in this order on a substrate by means of an atmospheric pressure CVD method to obtain a transparent conductive substrate for solar cells. Now, the first embodiment will be described with reference to this method.

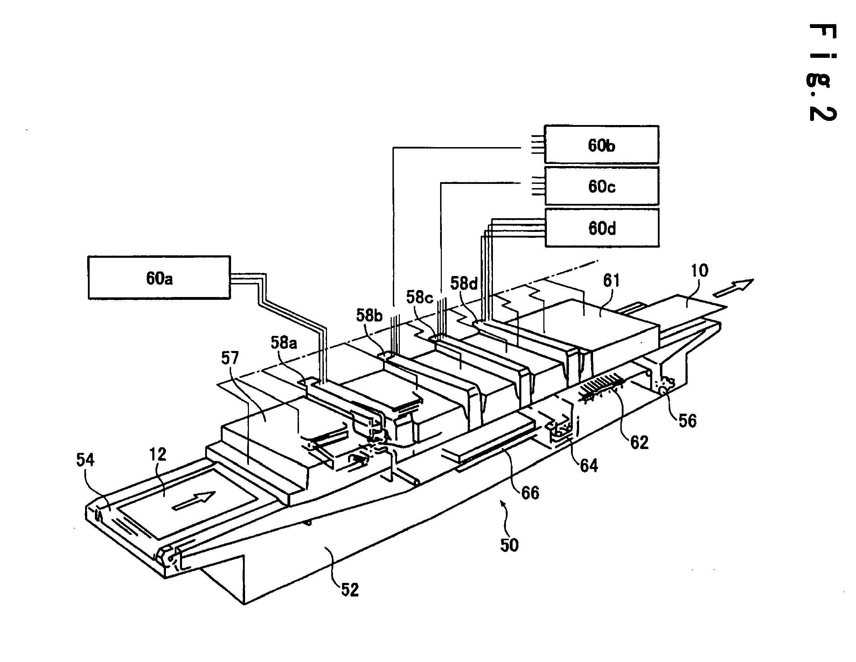

Fig. 2 is a schematic perspective view showing an example of an apparatus to be used for the production of the first embodiment of the transparent conductive substrate for solar cells of the present invention. The production apparatus 50 shown in Fig. 2 basically comprises the main body 52, a conveyer belt 54, a belt-driving device 56, gas-supply devices (injectors) 58a to 58d, gas flow rate-controlling devices 60a to 60d, a brush cleaner 62, an ultrasonic cleaner 64 and a belt dryer 66.

In the production apparatus 50 shown in Fig. 2, the conveyer belt 54 is provided on the main body 52, and the conveyer belt 54 having the substrate 12 placed thereon, is rotated by the belt-driving device 56, whereby the substrate 12 is moved in the direction of the arrow.

The substrate 12 is heated to a high temperature (e.g. 550°C) in a heating zone 57, while it is transported.

Then, onto the heated substrate 12, nitrogen gas and vaporized tetraisopropoxy titanium as the raw material for the titanium oxide layer 14 were blown in an amount controlled by the gas flow rate-controlling device 60a in a state carried by a curtain-like airstream uniform in the furnace width direction with its flow controlled by a gas supply device 58a. The tetraisopropoxy titanium undergoes a thermal decomposition reaction on the substrate 12, whereupon a titanium oxide layer 14 is formed on the surface of the substrate 12 in a state of being transported. Here, tetratitanium isopropoxide is put in a bubbler tank kept at a temperature of about 100°C accommodated in the gas flow rate-controlling device 60a, and vaporized by bubbling with nitrogen gas and transported to the gas supply device 58a by a stainless steel piping.

Then, on the substrate 12 having the titanium oxide layer 14 formed on its surface, oxygen gas and silane gas as the raw material for the silicon oxide layer 16 are blown in an amount controlled by the gas flow rate-controlling device 60b in a state carried by a curtain-like airstream uniform in the furnace width direction with its flow controlled by a gas supply device 58b. The silane gas and oxygen gas are mixed and reacted on the titanium oxide 14 layer of the substrate 12, whereupon a silicon oxide layer 16 will be formed on the surface of the titanium oxide layer 14 of the substrate 12 in a state of being transported.

Further, the substrate 12 having the silicon oxide layer 16 formed on its surface, is heated again to a high temperature (e.g. 540°C), and water and tin tetrachloride as the raw material for the first tin oxide layer 18 are blown in an amount controlled by a gas flow rate-controlling device 60c in a state carried by a curtain-like airstream uniform in the furnace width direction with its flow controlled by a gas supply apparatus 58c. The tin tetrachloride and water are mixed and reacted on the silicon oxide layer 16 of the substrate 12, whereupon a first tin oxide layer 18 not doped with fluorine is formed on the surface of the silicon oxide layer 16 of the substrate 12 in a state of being transported. Here, the tin tetrachloride is put into a bubbler tank maintained at a temperature of 55°C, vaporized by bubbling with nitrogen gas and transported to a gas supply device 58c by a stainless steel piping. Further, with respect to the water, steam obtained by boiling under heating is transported to the gas supply device 58c by a separate stainless steel piping.

Further, the substrate 12 having the first tin oxide layer 18 formed on its surface is heated again at a high temperature (e.g. 540°C), and hydrogen fluoride, water and tin tetrachloride as the raw material for the second tin oxide layer are blown in an amount controlled by a gas supply-controlling device 60d in a state carried by a curtain-like airstream uniform in the furnace width direction with its flow controlled by a gas supply device 58d. The tin tetraoxide, water and hydrogen fluoride are mixed and reacted on the first tin oxide layer 18 of the substrate 12, whereupon a second tin oxide layer 20 doped with fluorine is formed on the surface of the first tin oxide layer 18 of the substrate 12 in a state of being transported. Here, the tin tetrachloride and water are transported by the gas supply device 58d by the same method as for the first tin oxide layer 18. Further, with respect to the hydrogen fluoride, vaporized hydrogen fluoride is transported to a gas supply device 58d by a stainless steel piping and supplied onto the first tin oxide layer 18 in a state mixed with the tin tetrachloride.

While being transported, the substrate 12 having the second tin oxide layer 20 formed thereon, is passed through the annealing zone 61 and cooled to the vicinity of room temperature, and discharged as a transparent conductive substrate 10 for solar cells.

After removing the transparent conductive substrate 10 for solar cells, the conveyer belt 54 is cleaned by a brush cleaner 62 and an ultrasonic cleaner 64 and dried by a belt dryer 66.

The above-described method is an off line CVD method wherein formation of a transparent conductive substrate for solar cells is carried out in a separate process from the production of a substrate. In the present invention, it is preferred to employ such an off line CVD method with a view to obtaining high quality transparent conductive substrate for solar cells. However, it is also possible to employ an on line CVD method wherein formation of a transparent conductive film for solar cells is carried out, following the production of a substrate (such as a glass substrate).

Now, the second embodiment of the present invention will be described.

The second embodiment of the present invention is a transparent conductive substrate for solar cells, which has at least a silicon oxide layer and a tin oxide layer adjacent to the silicon oxide layer, formed on a substrate in this order from the substrate side, wherein the tin oxide layer has a thickness of from 600 to 1,000 nm; in the tin oxide layer, the fluorine concentration in a region (1) of up to 200 nm from the interface with the silicon oxide layer is not more than 20% of the fluorine concentration in a region (3) of up to 300 nm from the surface of the tin oxide layer on the side opposite to the substrate; and the fluorine concentration in a region (2) between the regions (1) and (3) in the tin oxide layer is at least the fluorine concentration in the region (1) and at most the fluorine concentration in the region (3).

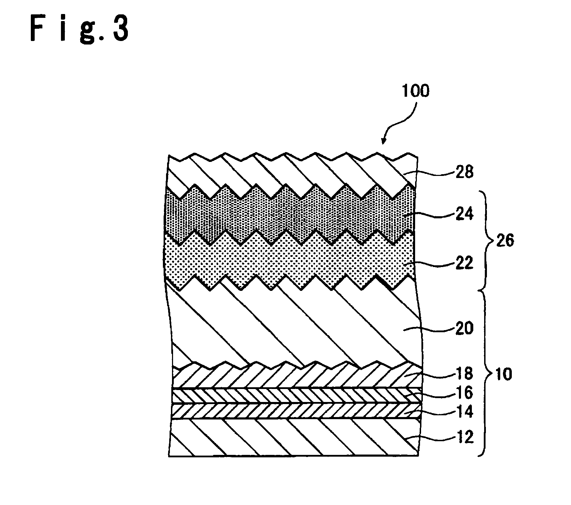

Here, the surface of the tin oxide layer on the side opposite to the substrate is meant for the surface (interface) of the multi-laminated tin oxide layers remotest from the substrate in a structure having a silicon oxide layer formed on the substrate and a plurality of tin oxide layers are laminated on the silicon oxide layer, and it is meant for the upper surface of the second tin oxide layer 20 as shown in Fig. 1. Further, in a case where the surface of the tin oxide layer on the side opposite to the substrate as irregularities as shown in Fig. 3, it is meant for the highest portion among the projections (the top of projections of the second tin oxide layer 20 remotest from the substrate 12, as shown in Fig. 3).

Further, if the relation between the regions (1), (2) and (3) and the first tin oxide layer, the second tin oxide layer et seq (i.e. if the third tin oxide layer etc. are present, such additional layers are included) is described with reference to the region (1) as an example, the region (1) will be the tin oxide film within a range of from 200 nm from the interface between the silicon oxide and the first tin oxide layer, and for example, in a case where the thickness of the first tin oxide layer is at least 200 nm, the region (1) is composed solely of the first tin oxide layer.

Further, for example, in a case where the thickness of the first tin oxide layer is 150 nm, the region (1) is constituted by the first tin oxide layer and the second tin oxide layer.

Thus, the regions (1), (2) and (3) may respectively be composed of a single tin oxide layer or a plurality of tin oxide layers.

Now, with respect to the second embodiment of the transparent conductive substrate for solar cells of the present invention, points different from the first embodiment of the transparent conductive substrate for solar cells of the present invention will be described.

In the first embodiment of the present invention, in the tin oxide layers adjacent to the silicon oxide layer, a region where the amount of fluorine doped is large and a region where it is small, are provided in the thickness direction by laminating a tin oxide layer doped with fluorine and a tin oxide layer not doped with fluorine. Whereas, in the second embodiment of the present invention, the embodiment may be such a laminated structure but is not limited thereto, and it is different in that the region where the amount of fluorine doped is large and the region where it is small may be provided in the thickness direction in the tin oxide layer adjacent to the silicon oxide layer, itself.

Specifically, in the second embodiment of the present invention, the thickness of the tin oxide layer is from 600 to 1,000 nm; in the tin oxide layer adjacent to the silicon oxide layer, the fluorine concentration in a region (1) of up to 200 nm from the interface with the silicon oxide layer is not more than 20% of the fluorine concentration in a region (3) of up to 300 nm from the surface of the tin oxide layer (the surface on the side opposite to the silicon oxide layer); and the fluorine concentration in a region (2) between the regions (1) and (3) of the tin oxide layer is at least the fluorine concentration in the region (1) and at most the fluorine concentration in the region (3).

Namely, the relation of the fluorine concentrations in the regions (1) to (3) in the tin oxide layer is any one of the following (A), (B) and (C).
(A): The fluorine concentration in the region (2) is at least the fluorine concentration in the region (1) and less than the fluorine concentration in the region (3).
(B): The fluorine concentration in the region (2) exceeds the fluorine concentration in the region (1) and at most the fluorine concentration in the region (3).
(C): The fluorine concentration in the region (2) exceeds the fluorine concentration in the region (1) and less than the fluorine concentration in the region (3).

Thus, in the first embodiment of the present invention, the first tin oxide layer is a layer not doped with fluorine, and the second tin oxide layer is a layer doped with fluorine, whereby the same effect as an embodiment wherein the thickness of the first tin oxide layer is at least 10 nm, is obtainable. Namely, it is possible to reduce the absorption of near infrared light by reducing the amount of fluorine as a whole, while securing the excellent electrical conductivity in the plane direction in the region (3) (or in the region (3) and the region (2)) where the amount of fluorine is large, and in an embodiment having a titanium oxide layer between the substrate and the silicon oxide layer, the haze factor can be made sufficiently large even in a case where the substrate is a glass containing alkali metal ions.

The fluorine concentration in the region (1) is preferably from 0.002 to 0.4 mol%, more preferably from 0.004 to 0.02 mol%, to SnO₂.

The fluorine concentration in the region (3) is preferably from 0.01 to 2 mol%, more preferably from 0.02 to 1 mol%, to SnO₂.

The second embodiment of the transparent conductive substrate for solar cells of the present invention is not particularly restricted with respect to the method for its production. For example, a method may preferably be mentioned wherein at least a silicon oxide layer, and a tin oxide layer (a tin oxide layer wherein the fluorine concentration in the region (1) is not more than 20% of the fluorine concentration in the region (3), and the fluorine concentration in the region (2) is at least the fluorine concentration in the region (1) and at most the fluorine concentration in the region (3)) are formed on a substrate in this order by means of an atmospheric pressure CVD method, to obtain a transparent conductive substrate for solar cells.

The method for forming the titanium oxide layer and the silicon oxide layer may be the same as in the method for producing the first embodiment of the transparent conductive substrate for solar cells of the present invention.

The method for forming the tin oxide layer may, for example, be a method wherein while a substrate having a silicon oxide layer formed thereon is being moved, from a plurality of gas supply devices disposed along the direction of the movement of the substrate, a source gas having a hydrogen fluoride concentration increased from upstream towards downstream, is blown onto the substrate. More specifically, in a method wherein a gas stream comprising tin-tetrachloride, water and hydrogen fluoride, as a source gas, is blown from the gas supply device onto the surface of the silicon oxide layer of the substrate in a state of being transported, to form a tin oxide layer, the concentration of hydrogen fluoride in the source gas at the upstream is made lower than the concentration of hydrogen fluoride in the source gas at the downstream.

By this method, the fluorine concentration in the region (1) of the tin oxide layer formed at the upstream can be made lower than the fluorine concentration in the region (3) of the tin oxide layer formed at the downstream.

Now, a solar cell of the present invention will be described.

The solar cell of the present invention is a solar cell employing the first or second embodiment of the transparent conductive substrate for solar cells of the present invention.

The solar cell of the present invention may be a solar cell with either one of an amorphous silicon type photoelectric conversion layer and a fine crystal silicon type photoelectric conversion layer. Further, it may be of either a single structure or a tandem structure. Particularly preferred is a solar cell of a tandem structure.

As one of preferred embodiments of the solar cell of the present invention, a solar cell of a tandem structure may be mentioned wherein the first or second embodiment of the transparent conductive substrate for solar cells of the present invention, a first photoelectric conversion layer, a second photoelectric conversion layer an a rear electrode layer are laminated in this order, may be mentioned.

Fig. 3 is a schematic cross-sectional view illustrating an example of the solar cell of a tandem structure employing the first embodiment of the first conductive substrate for solar cells of the present invention. In Fig. 3, the incident light side of the solar cell is located on the down side of the drawing.

The solar cell 100 shown in Fig. 3 comprises the first embodiment of the transparent conductive substrate 10 for solar cells of the present invention, a semiconductor layer (a photoelectric conversion layer) 26 comprising a first photoelectric conversion layer 22 and a second photoelectric conversion layer 24, and a rear electrode layer 28. This is a common construction of a thin layer solar cell of a tandem structure.

In the solar cell 100, light enters from the side of the transparent conductive substrate 10 for the solar cell. Each of the first photoelectric conversion layer 22 and the second photoelectric conversion layer 24 has a pin structure in which a p-layer, an i-layer and an n-layer are laminated in this order from the incident light side. Here, in the first photoelectric conversion layer 22 on the incident light side, the p-layer, the i-layer and the n-layer are made of amorphous silicon having a large band gap Eg. On the other hand, in the second photoelectric conversion layer 24 located at a further downstream side against the incident light, the p-layer, the i-layer and the n-layer are made of a crystal silicon such as a single crystal silicon, a poly-crystal silicon or a microcrystal silicon.

In Fig. 3, the second photoelectric conversion layer 24 is constructed by only one layer, but it may be constructed by laminating a plurality of photoelectric conversion layers which are different in the band gap Eg from one another. In a case where the second photoelectric conversion layer is constructed by laminating a plurality of photoelectric conversion layers, such layers are laminated so that the band gap Eg will be smaller towards the downstream from the incident light side.

Light entered into the solar cell 10 will be absorbed by either the first photoelectric conversion layer 22 or the second photoelectric conversion layer 24, whereby an electromotive force will be generated by a photoconduction effect. The electromotive force thus generated is taken out to the outside by means of the second tin oxide layer 20 being a transparent conductive film of the transparent conductive substrate 10 for solar cells, and the rear electrode layer 28, as electrodes. The solar cell 100 has the first photoelectric conversion layer 22 and the second photoelectric conversion layer 24 which are different from each other in the band gap Eg, whereby the sunlight energy can be effectively utilized within a wide range of spectrum, and the photoelectric conversion efficiency will be excellent. Such effects will be further distinct by providing the second photoelectric conversion layer by laminating photoelectric conversion layers different in the band gap Eg from one another so that Eg will be smaller towards the downstream side from the incident light side.

The solar cell may have another layer, for example, a contact-improvement layer between the rear electrode layer 28 and the second photoelectric conversion layer 24. By providing the contact-improvement layer, the contact between the rear electrode layer 28 and the second photoelectric conversion layer 24 can be improved.

The tandem type solar cell as shown in Fig. 3 is excellent in the photoelectric conversion efficiency as compared with a conventional single type amorphous silicon solar cell. In the present invention, the absorption of near infrared light by the tin oxide layer is small, and a transparent conductive substrate for solar cells, which is excellent in the photoelectric conversion efficiency is employed, whereby the merits of the solar cell of a tandem structure will effectively be provided.

The solar cell shown in Fig. 3 can be produced by a conventional method. For example, a method may be mentioned wherein the first photoelectric conversion layer 22 and the second photoelectric conversion layer 24 are sequentially formed on the transparent conductive substrate 10 for solar cells by means of a plasma CVD method, and further, the rear electrode layer 28 is formed by means of a sputtering method. In the case of forming a contact improvement layer, it is preferred to employ a sputtering method.

### EXAMPLES

### 1. PREPARATION OF TRANSPARENT CONDUCTIVE SUBSTRATE FOR SOLAR CELLS

### EXAMPLE 1

A transparent conductive substrate for solar cells was prepared by means of an off line CVD apparatus of such a type that a plurality of gas supply devices are attached to a tunnel type heating furnace for transporting a substrate by a mesh belt. Specifically, as described below, on a glass substrate, a titanium oxide layer, a silicon oxide layer, a first tin oxide layer not doped with fluorine, a second tin oxide layer doped with fluorine and a third tin oxide layer doped with fluorine were formed in this order to obtain a transparent conductive substrate for solar cells having such five layers laminated on the glass substrate.

Firstly, while the glass substrate was being transported, it was heated to 550°C in a heating zone.

Then, onto the heated substrate, vaporized tetraisopropoxy titanium as the raw material for a titanium oxide layer and nitrogen gas as a carrier gas were blown by a gas supply device to form a titanium oxide layer on the surface of the substrate in a state of being transported. The thickness of the titanium oxide layer was 12 nm. Here, tetratitanium isopropoxide was put into a bubbler tank kept at a temperature of about 100°C and vaporized by bubbling with nitrogen gas and transported to the gas supply device by a stainless steel piping.

Then, the substrate having the titanium oxide layer formed on its surface, was heated again at 550°C and then, silane gas as the raw material for a silicon oxide layer, oxide gas, and nitrogen gas as a carrier gas were blown thereonto by a gas supply device, to form a silicon oxide layer on the surface of the titanium oxide layer of the substrate in a state of being transported. The thickness of the silicon oxide layer 30 nm.

Further, the substrate having the silicon oxide layer formed on its surface was heated again to 540°C, and then tin tetrachloride as the raw material for a first tin oxide layer, water and nitrogen gas as a carrier gas were blown thereonto by a gas supply device, to form a first tin oxide layer not doped with fluorine, on the surface of the silicon oxide layer of the substrate in a state of being transported. Here, tin tetrachloride was put into a bubbler tank, kept at a temperature of about 55°C, vaporized by bubbling with nitrogen gas and transported to the gas supply device by a stainless steel piping. Further, with respect to the water, steam obtained by boiling under heating was transported to the gas supply device by another stainless steel piping.

Further, the substrate having the first tin oxide layer formed on its surface was heated again to 540°C, and then, by a gas supply device, tin tetrachloride as the raw material for a second tin oxide layer, water and nitrogen gas as a carrier gas were blown thereonto to form a second tin oxide layer doped with fluorine, on the surface of the first tin oxide layer of the substrate in a state of being transported. Here, tin tetrachloride and water were transported to the gas supply device in the same manner as in the case for the first tin oxide layer. Further, with respect to the hydrogen fluoride, vaporized hydrogen fluoride was transported to the gas supply device by a stainless steel piping and supplied in a state as mixed with tin tetrachloride onto the first tin oxide layer.

Further, the substrate having the second tin oxide layer formed on its surface was heated again to 540°C, and then, by a gas supply device, tin tetrachloride as the raw material for a third tin oxide layer, water, hydrogen fluoride and nitrogen gas as a carrier gas were blown thereonto to form a third tin oxide layer doped with fluorine, on the second tin oxide layer of the substrate in a state of being transported. Here, tin tetrachloride, water and hydrogen fluoride were transported to the gas supply device in the same manner as the case for the second tin oxide layer.

The obtained third tin oxide layer had fine irregularities (texture) uniformly on the film surface.

The mixing ratio of water to tin chloride was adjusted to H₂O/SnCl₄=80 by molar ratio in each of the first tin oxide layer, the second tin oxide layer and the third tin oxide layer. Further, the thickness of each of the first tin oxide layer, the second tin oxide layer and the third tin oxide layer was adjusted to be 270 nm, and the total thickness was 810 nm.

Further, the amount of hydrogen fluoride added to each of the second tin oxide layer and the third tin oxide layer was HF/SnCl₄=0.4 by molar ratio.

While being transported, the substrate having the third tin oxide layer formed, was passed through an annealing zone and cooled to near room temperature, to obtain a transparent conductive substrate for solar cells.

### EXAMPLES 2 TO 5 AND COMPARATIVE EXAMPLES 1 TO 7

Transparent conductive substrates for solar cells were obtained in the same manner as in Example 1 except that in the first tin oxide layer, the second tin oxide layer and the third tin oxide layer, the thicknesses, the HF/SnCl₄ molar ratios and the H₂O/SnCl₄ molar ratios were changed as shown in Table 1.

Further, in Comparative Examples 1 to 7, formation of the first tin oxide layer doped with fluorine was carried out in the same manner as for the formation of the second tin oxide layer in Example 1 except that the HF/SnCl₄ molar ratio was changed as shown in Table 1.

### 2. EVALUATION OF PHYSICAL PROPERTIES

With respect to the transparent conductive substrates for solar cells obtained as described above, the physical properties were evaluated as follows.

### (1) FLUORINE CONCENTRATION DISTRIBUTION IN TIN OXIDE LAYER

With respect to a sample for measurement cut out from a transparent conductive substrate for solar cells, the fluorine concentration distribution in the thickness direction in the tin oxide layer was measured by means of SIMS (ADEPT1010 model, manufactured by ULVAC-PHI, INCORPORATED). The fluorine concentration was evaluated by the count ratio of F⁻ secondary ions to SnO⁻ secondary ions (19 F/120 Sn).

Specifically, the fluorine concentrations in the region (1) of up to 200 nm from the interface of the tin oxide layer with the silicon oxide layer, the region (3) of up to 300 nm from the surface of the tin oxide layer and the region (2) between the regions (1) and (3), were measured, and the average values in the thickness direction were calculated.

The conditions for the SIMS analysis were such that etching ions were O₂, the accelerating voltage was 5 kV, and the beam current was 200 nA.

The results are shown in Table 1.

Here, the source gas supplied from the film forming device was at a uniform flow rate over the entire region in the width direction of the substrate, and in principle, there is no change in the flow rate in the advance direction in the substrate, whereby it is considered that there will be no variation in the concentration of the raw material at various portions over the entire surface of the substrate. Therefore, a typical portion of the substrate was selected and cut out to obtain a sample for measurement.

### (2) HAZE FACTOR FOR ILLUMINANT C

With respect to a sample for measurement cut out from a transparent conductive substrate for solar cells, the haze factor for illuminant C was measured by means of a haze meter (HZ-1 model, manufactured by SUGA TEST INSTRUMENTS Co., Ltd.). The results are shown in Table 1. Here, the illuminant C is a standard light prescribed by CIE (Commission International de l'Eclairage). This is used to represent the color of object irradiated with daylight approximate to a color temperature of 6,774 k. Further, the haze factor is a value when the proportion of the formula (Td-Tn)/Td where Td is the diffuse transmittance and Tn is the specular transmittance, is represented by percentage.

Here, the haze factor of the entire surface of the substrate is visually substantially uniform. Therefore, a typical portion of the substrate was selected and cut out to obtain a sample for measurement.

### (3) ABSORPTION OF NEAR INFRARED LIGHT

With respect to a sample for measurement cut out from a transparent conductive substrate for solar cells, the spectral transmittance and the reflectance were measured by means of a spectrophotometer (UV3100PC, manufactured by Shimadzu Corporation. When a substrate having a haze is measured, a phenomenon is likely to occur such that light is trapped in the tin oxide film and leaks out from an end of the sample. Accordingly, as the substrate has a higher haze factor, the measured value tends to be lower. In order to avoid such an error in measurement, a sample for measurement was prepared by means of a method (IM method) to substantially remove a haze by bringing a synthetic quartz substrate in close contact with the tin oxide film surface of the substrate, and a filling space with a high refraction solution

### (diiode methane).

Firstly, the transmittance and the reflectance were measured, and then, they were deducted from 100% to obtain a value including absorptivity of all of the glass substrate, the undercoating layer (the layer between the glass substrate and the tin oxide layer) and the tin oxide layer.

Then, with respect to a sample having the tin oxide film of the substrate removed by etching (the glass substrate + the undercoating layer), the measurement and calculation were carried out in the same manner to obtain a value for the absorptivity of the absorbing components of the glass substrate and the undercoat layer. This value was deducted from the entire absorption previously obtained to calculate the spectral absorptance of only the tin oxide layer approximately. The absorption attributable to free electrons starts in the vicinity of 700 nm and increases towards near infrared. As an index to show the influence of such a component to the transmittance, the absorption at 1,000 nm was selected to evaluate the quality level.

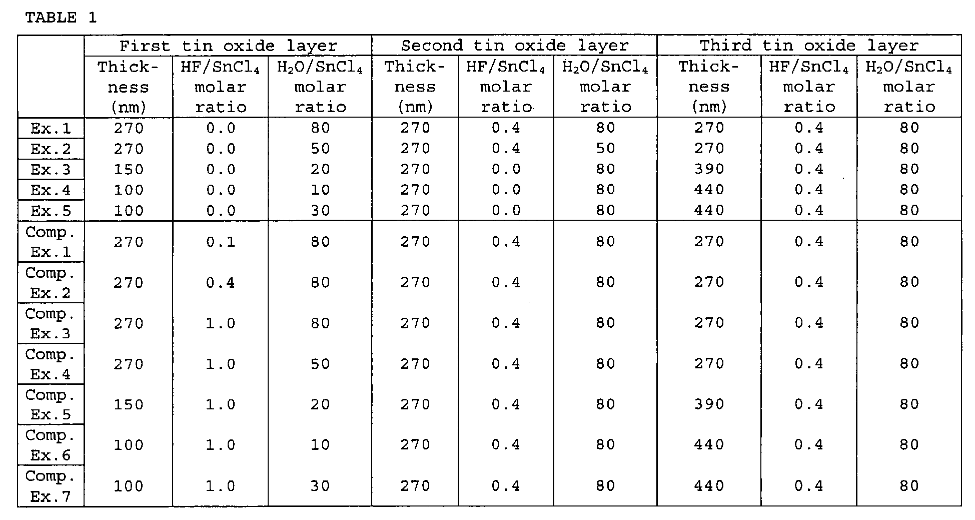

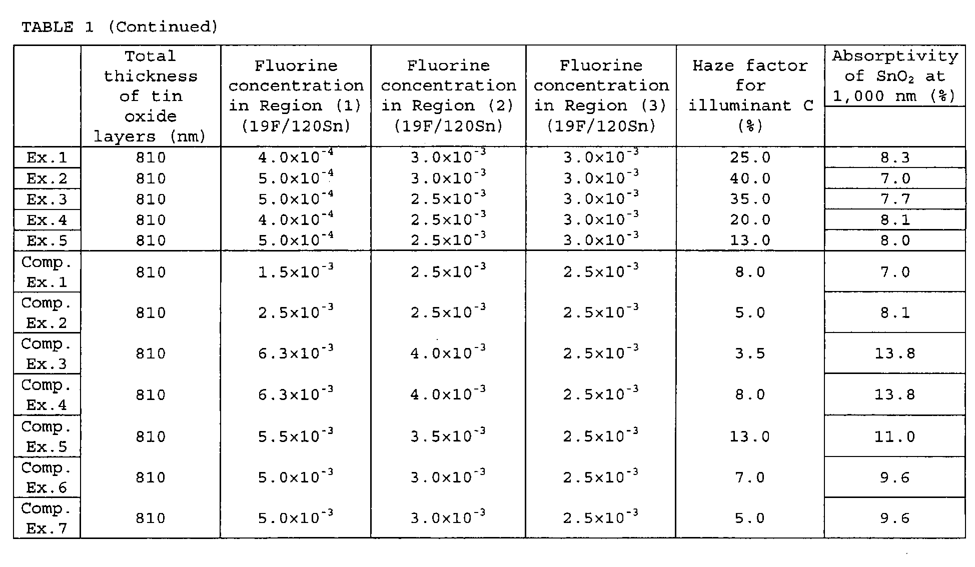

As is evident from Table 1, with the transparent conductive substrates for solar cells of the present invention (Examples 1 to 5), the haze factor was high even in a case where a titanium oxide layer was present between the substrate and the silicon oxide layer. Further, in the transparent conductive substrates for solar cells of the present invention, the fluorine concentration was low in the vicinity of the interface with the silicon oxide layer, which is considered to be one factor for the high haze factor.

Further, the resistance and the absorption of near infrared light were measured, whereby it was found that with the transparent conductive substrates for solar cells of the present invention (Examples 1 to 5), the resistance was low, and the absorption of near infrared light was low, as compared with the transparent conductive substrates for solar cells in Comparative

### Examples.

As shown in Examples, according to the present invention, it is possible to simultaneously accomplish that the haze value is maintained at a high value of at least 10% and that the absorptivity at 1,000 nm is less than 10%. Further, as shown in Examples, even if the haze factor is substantially changed from 13% to 40%, the absorptivity can be fixed at a low value of about 7 to 8, and accordingly, even if a transparent conductive substrate is prepared by adjusting the haze factor to the level required for solar cells, it is possible to present one having an absorptivity of near infrared light being low at the same level.

### INDUSTRIAL APPLICABILITY

The transparent conductive substrate for solar cells of the present invention, wherein the resistance of the tin oxide layer is low, the absorption of near infrared light in the tin oxide layer is low, and the haze factor will not deteriorate even in a case where a titanium oxide layer is present between the substrate and the silicon oxide layer, is very useful for producing solar cells having high photoelectric conversion efficiency.

The entire disclosure of Japanese Patent Application No. 2005-333185 filed on November 17, 2005 including specification, claims, drawings and summary is incorporated herein by reference in its entirety.

## Claims

1. A transparent conductive substrate for solar cells, which has at least two types of layers including a silicon oxide layer and multi-laminated tin oxide layers adjacent to the silicon oxide layer, formed on a substrate in this order from the substrate side, wherein the multi-laminated tin oxide layers include at least one tin oxide layer doped with fluorine and at least one tin oxide layer not doped with fluorine.

2. The transparent conductive substrate for solar cells according to Claim 1, wherein a first tin oxide layer being a tin oxide layer adjacent to the silicon oxide layer is the tin oxide layer not doped with fluorine.

3. The transparent conductive substrate for solar cells according to Claim 2, wherein the fluorine concentration in the first tin oxide layer is not more than 20% of the fluorine concentration in the tin oxide layer doped with fluorine.

4. The transparent conductive substrate for solar cells according to Claim 2 or 3, wherein the first tin oxide layer has a thickness of at least 10 nm.

5. A transparent conductive substrate for solar cells, which has at least two types of layers including a silicon oxide layer and a tin oxide layer adjacent to the silicon oxide layer, formed on a substrate in this order from the substrate side, wherein the tin oxide layer has a thickness of from 600 to 1,000 nm; in the tin oxide layer, the fluorine concentration in a region (1) of up to 200 nm from the interface with the silicon oxide layer is not more than 20% of the fluorine concentration in a region (3) of up to 300 nm from the surface of the tin oxide layer on the side opposite to the substrate; and the fluorine concentration in a region (2) between the regions (1) and (3) in the tin oxide layer is at least the fluorine concentration in the region (1) and at most the fluorine concentration in the region (3).

6. The transparent conductive substrate for solar cells according to any one of Claims 1 to 5, which further has a titanium oxide layer between the substrate and the silicon oxide layer.

7. A solar cell employing the transparent conductive substrate for solar cells according to any one of Claims 1 to 6.

8. A method for producing a transparent conductive substrate for solar cells, which comprises forming at least 3 types of layers including a silicon oxide layer, a tin oxide layer not doped with fluorine and a tin oxide layer doped with fluorine, in this order on a substrate, by means of an atmospheric pressure CVD method, to obtain a transparent conductive substrate for solar cells.

9. A method for producing a transparent conductive substrate for solar cells, which comprises forming at least two types of layers including a silicon oxide layer and a tin oxide layer, in this order on a substrate, by means of an atmospheric pressure CVD method, to obtain a transparent conductive substrate for solar cells, wherein onto the substrate having the silicon oxide layer formed thereon, the tin oxide layer is formed by blowing a source gas having a hydrogen fluoride concentration increased from upstream towards downstream while the substrate is being moved, from a plurality of gas supply devices disposed along the direction of the movement of the substrate.
